# EUROPEAN PATENT APPLICATION

(11) **EP 4 160 463 A1**
(43) Date of publication of application: **05.04.2023**
(21) Application number: 22197396.9
(22) Date of filing: 23.09.2022
(51) Int. Cl.: G06F 30/13, G06F 30/27

(54) **SYSTEM AND METHOD FOR DESIGNING GREEN AREAS**

(30) Priority: 29.09.2021 IT 202100024869
(71) Applicant: Ecobubble S.r.l. Startup Costituita Ai Sensi Dell'Art. 4 Comma 10 Bis D.L. 3/2015 Conv. Con. Legge 33/2015, 00162 Rome (IT)
(72) Inventor: NESCATELLI, Nicola, 00100 ROME (IT); PROCACCINI, Andrea, 00054 FIUMICINO (RM) (IT)
(74) Representative: Bellomia, Paolo

(57) **Abstract**

Described is a system for designing green areas (1) comprising:
- a graphical interface module (2) designed to acquire a plurality of input data representing the shape of a green area to be designed, any pollutants present in the green area and design aims;
- a processing module (4) designed to combine the input data with system data representing characteristics of the plants to be used and design parameters and to send it to an artificial intelligence module (6) located in a remote server;
- a plurality of sensors (8) designed to be positioned in the green area for acquiring measurement data representing physical parameters of the green area and sending it to the artificial intelligence module 6, said artificial intelligence module (6) being designed to process the input data, the system data and the measurement data on the basis of predetermined physical-mathematical and artificial intelligence models in order to obtain output data representing a set of plants to be used, their number and their spatial arrangement inside the green area.

## Description

This invention relates to a system and method for designing green areas.

In particular, the invention relates to an online design system which generates a green environmental mitigation project based on knowledge of local pollutants or mitigation objectives.

Italy is among the leading countries in Europe in terms of impact on human health (with regard to premature deaths and years of life lost) due to various types of pollution: PM2.5, NO2, O3 (EEA Report No 9/2020, "Air quality in Europe"). Between 2008 and 2017, Italy violated in a systematic and continuous manner (according to judgement dated 10 November 2020 of the EU Court of Justice) the EU limit values on concentrations in the air of PM10, one of the main risk factors for human health according to the WHO.

This situation also has a direct impact on the country's economy. In 2016, the relative losses due to pollution were estimated to be more than 20 million euros, a sad record in Europe.

There is therefore a need to promote the use of urban green spaces as a sustainability tool, facilitating their design, implementation and maintenance.

Green areas have known beneficial effects, including the ability to absorb different types of pollutants present in the air, soil and in water, as well as ambient noise and greenhouse gases.

The design of green areas, and specifically the selection of plant species, their spatial distribution and their maintenance, is usually carried out starting from considerations such as water availability, surface areas, luminosity, temperature and soil conditions.

The following documents describe prior art solutions:
- document PCT/US2020/057237 *(System and method for generating a landscape design*);
- document PCT/US2006/032813 *(On-line design system and methodologies*);
- document GB 2439376 A *(Flexi Garden Design*).

Rarely are the green area projects prepared considering requests for environmental decontamination or quantification of emissions absorbed by the green areas, as the systems and methodologies for the design of green areas with environmental mitigation objectives usually require multidisciplinary skills and many professionals (architects, botanists, physicists, chemists, environmental engineers, etc.), and involve a very slow, laborious and costly design process.

The management can also be complex and, above all, it is not possible to verify the actual amount of pollutants absorbed.

On-line design systems are known which, however, do not prepare projects with environmental mitigation objectives, that is to say, the plants are not selected and positioned in such a way as to optimise the absorption of pollutants, greenhouse gases and noise.

In addition, current designs are not easily scalable based on mitigation objectives and user budget constraints.

The aim of the invention is therefore to provide a system and a method for designing innovative green areas, which is optimised for environmental mitigation (soil, air, water, noise, greenhouse gases) and which is completely online, thus overcoming the above-mentioned problems of the prior art.

This and other aims are achieved with a system for designing green areas whose features are defined in claim 1, and with a method for designing green areas whose features are defined in claim 8.

Particular embodiments are the subject of dependent claims, the content of which is to be considered as an integral part of this description.

Further features and advantages of the invention are apparent from the detailed description which follows, presented purely by way of a non-limiting example, with reference to the accompanying drawings, in which:
- Figure 1 is a schematic view of a system for designing green areas according to the invention; and
- Figure 2 shows a block diagram of the steps of a method for designing green areas according to the invention.

In short, the system according to the invention is of the data-driven type and uses the integration of a series of technologies such as Phytoremediation, Machine learning, Spectrography and Cloud Computing.

In particular, artificial intelligence modules are used to exploit in a coordinated manner data coming from laboratories, scientific literature, sensors or validations in the field and process them by means of a cloud processor to offer increasingly effective designs for each cycle of use.

The system according to the invention is based on a web platform which provides a user with a tool which integrates artificial intelligence and data-driven logic, to design a space on the basis of predetermined characteristics, selecting plants which best handle various pollutants (atmosphere, water, soil, noise) and greenhouse gases, and also provides details on where to position them and how to manage them.

The web platform (system) comprises a plurality of known data acquisition and processing modules designed to process groups or modules of programs stored on a disc or accessible on the Internet.

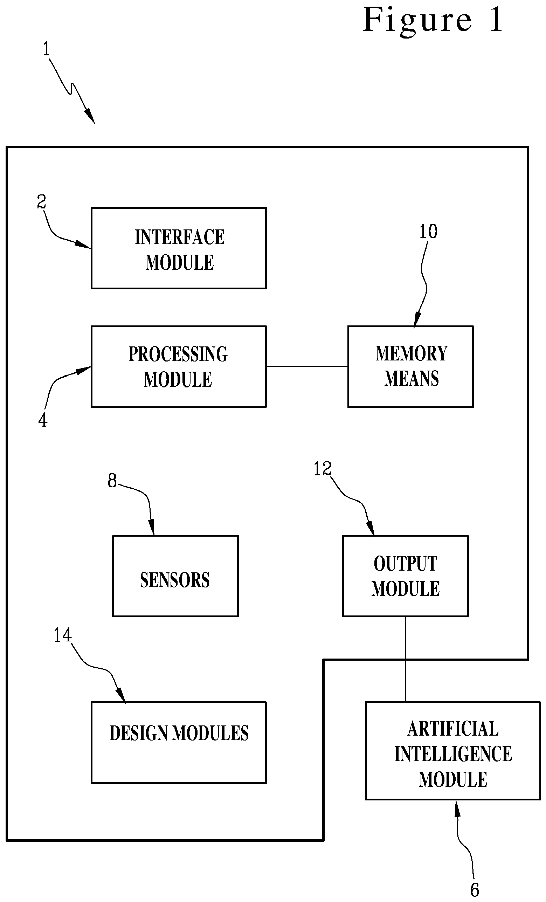

Figure 1 shows a schematic view of a system (web platform) for designing green areas 1 according to the invention

The system 1 comprises a graphical interface module 2 designed to acquire a plurality of input data, entered by a user, representing the shape of a green area (territory) to be designed (such as, for example, location, altitude, shape and size of the area to be designed, shaded areas), any pollutants present in the green area and design objectives (such as, for example , colours and aesthetic preferences).

The system 1 also comprises a processing module 4, connected to the interface module 2, designed to combine the input data with system data representing features of the plants to be used (such as, for example, type of plants, flowering, habitus, parasites) and design parameters (such as desired distance between plants, weather of the zone in which the green area is located, planned irrigation, etc.) and to send them to an artificial intelligence module 6 located in a remote server (in the cloud).

The system 1 also comprises a plurality of sensors 8, such as, for example, hygrometers, actuators, multispectral cameras, thermometers, designed to be positioned in the green area for acquiring measurement data representing physical parameters of the green area and sending it to the artificial intelligence module 6, which processes them, together with the input and system data, as described in detail below, to obtain output data.

The system data is predetermined and stored in memory means 10 associated with the processing module 4.

The system data comprise a database which integrates various databases of known type. In particular, the database contains a plurality of plants (advantageously 600 plants) catalogued in terms of pollutant emissions and greenhouse gases, microclimates, habitus, growth dynamics, noise absorption, irrigation and luminous regimes.

Advantageously, the database also contains external data (weather services, satellite data such as spectrography, data from drones or monitoring services such as ARPA, environmental analysis data, literature data, environmental noise data) relating to:
- distribution of pollutants on the territory;
- weather reports;
   - vigour values of the plants (from local sensors, satellite detectors).
Lastly, the system 1 comprises an output module 12, connected to the artificial intelligence module 6 and to the processing module 4, designed for displaying said output data, which represent a set of plants to be used, their number and their spatial arrangement inside the green area. Moreover, the output data contain a report of the emissions absorbed by the plants, a description of the management of the green area to be implemented and, advantageously, a quotation for purchasing the species requested with the best price amongst plant suppliers associated with the system 1. The report generated also allows the release of documentation ready for a subsequent phase of certification of the green area in terms of carbon neutrality or, more generally, of balance of pollutant/greenhouse gas emissions.

The system 1 also comprises a plurality of design modules 14 designed to interface with the artificial intelligence module 6 and corresponding to respective mitigation objectives, in particular:
- a module for the automated design of a roof garden area as a function of the local pollutants;
- a module for the automated design of parks, urban allotments and green areas as a function of the local pollutants
- an automated module for the design of a green area as a function of Carbon Neutrality/GHG Emission Offset objectives;
- a module for monitoring the vigour of the plants;
- an irrigation management module;
- a module for the automated design of a green area as a function of the reduction of pollutants and the production of biomass (for the reclamation of landfills and other polluted areas);
- a module for the automated design of a green area as a function of noise reduction.

The modules for monitoring the vigour of the plants and for managing irrigation can be used in combination with all the other modules and require a plurality of data coming from the sensors 8.

The artificial intelligence module 6 is designed to apply known physical-mathematic models and artificial intelligence to the complete data and to the measurement data, to obtain the output data.

In particular, the artificial intelligence module 6 comprises a plurality of specific modules 6a, 6b and 6c designed to perform various operations.

A first specific module 6a is used for continuously improving the responsiveness to variations in vigour. This module 6a produces forecast analysis of the reflectance spectra of the various plant species used in system 1 as a function of the water correction carried out.

The reflectance spectra are acquired of the various plant species according to the design modules 14 (parks, roof gardens, reclamation areas, ... ) using multispectral cameras (subgroup of measurement data acquired by the sensors 8) in a laboratory (or in designed green areas that also have an automation system).

These reflectors are stored in the memory means 10, depending on specific characteristics of interest of each plant (water stress, parasites, vegetative cycles, ...). At this point a machine learning algorithm is used, trained using this series of data already categorised on the plants and relating to the characteristics of these spectra, to perform a predictive analysis of the behaviour as a function of characteristics of interest.

Following each data collection cycle of the integrated curves of the spectra, this machine learning algorithm improves the forecast analyses of the spectral behaviours. Consequently, there is the possibility of having, from a quantitative measurement, a specific state of vigour of each plant, which is connected to the characteristics of interest, without the need to use a known generic index, such as NDVI.

In this way, upon the first changes in the spectrum, it is possible to calculate the future estimate for the curve and the reasons for the change so as to act to return the reflectance spectrum to the state corresponding to an optimum vigour. This first specific module 6a radically changes the way of knowing and monitoring the green areas, since it is the plants themselves to suggest how much water makes then thrive, if they have parasites and what type of parasite type have, and what can be done depending on the changes in their state.

A second specific module 6b learns to distribute the plants spatially according to the species in order to optimise the absorption of the pollutants. By crosschecking all acquired data (input data, system data, measurement data), the second specific module 6b determines which plants are best to absorb predetermined local greenhouse gas pollutants (soil, air, water, noise). The data is collected at each cycle and a forecast of the environmental mitigations of the species investigated is generated. In this way, the optimum configuration for absorbing the pollutants is calculated: both the type of the various plants to be used and their spatial distribution within the green area to be designed are identified. Each data collection iteration is associated with a predetermined degree of vigour of the individual species (measured by the reflectance spectrum), in order to learn whether the plants currently used are, depending on the environment and environmental mitigations, actually the best which can be selected to absorb pollutants.

The laboratory, literature or historical data may differ from those measured on site. For example, in a first instant of time t=t0 a first plant A and a second plant B are the best plants for absorbing predetermined pollutants C, D, in a predetermined environment. After n collection cycles the spectrum can differ from the optimum vigour regime and this indicates that, under these environmental variables, there is a stress due to poor tolerance of the first plant A to a secondary pollutant (or to a hidden variable). The model, from the next cycle n+1, therefore replaces the first plant A in the design of the environment X, with a new group of plants. In the same way, if the first plant A in the first instant of time t=t0 must have a predetermined quantity of irrigation water according to data of the literature and after n cycles the second specific module 6b detects a water stress, the irrigation regime is changed. Other changes can also be identified with the same logic. Artificial intelligence also makes it possible to create more vegetation and spatial distribution variants, which are optimised to absorb the pollutants. The second specific module 6b thus also extracts possible choices of design and flowering colours and therefore creates variants, within an optimal or required environmental mitigation range.

A third specific module 6c is used to improve design efficiency in the absence of local sensors. The system 1 is designed to prepare designs regardless of the local sensors 8: the design modules 14 can in fact be used in combination with the local sensors 8 or by themselves. In the absence of local sensors 8, the green area design automation procedures initially optimise, in a first instant of time t=t0, the configuration based on that of prior art environments present in the vicinity. The choice of configuration that is made every time at the moment of the design takes into account all the past choices and the system 1 learns how to make ever better choices. For example, the user requires the design with main pollutants C, D of an X1 environment. The system 1 already knows the plant configurations and the geometries which optimise environments X2 and X3. Starting from the known data, the third artificial intelligence module 6c selects a combination of the configurations of the known environments as a function of the characteristics of X2 and X3. The main objective of the practical use of the third artificial intelligence module 6c in the design is to simulate the best possible efficiency, starting from known data but with different system specifications (environment, pollutants, etc.).

The models are differentiated into design modules for selection optimisations, distribution, quantification of emissions/pollutants absorbed and green management.

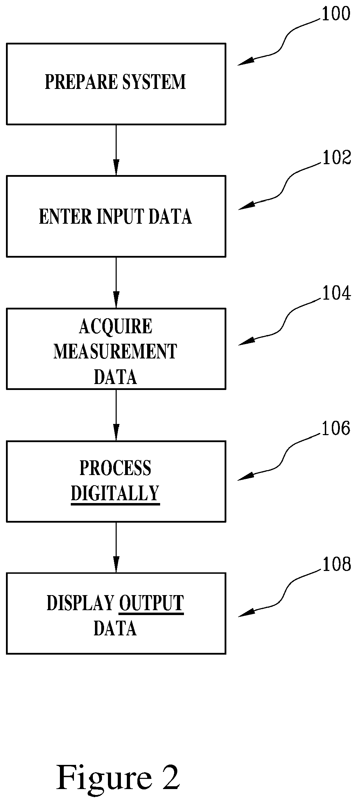

Figure 2 shows a block diagram of the steps of a method for designing green areas according to the invention.

The method starts in a step 100 in which a system is prepared for designing green areas 1 as described above.

Subsequently, in a step 102, a user enters the input data, using the graphical interface module 2.

In a step 104 the sensors 8 acquire the measurement data.

In a subsequent step 106, the interface module 6 digitally processes the input data, the system data and the measurement data by applying known physical-mathematic models and artificial intelligence such as phytoremediation (technology that studies how plants mitigate pollutants), multispectral analysis (technology for active monitoring of plant vigour) and machine learning (technology to build adaptive management and selection models), thus obtaining the output data to produce an efficient green area design solution.

Lastly, in a step 108, the artificial intelligence module 6 sends the output data to the output module 12 which displays them, for example, by means of a display unit.

The system 1 according to the invention may be used by various users: green area designers, public administrations, designers and builders of smart-green buildings, companies engaged in carbon neutrality, companies specialised in green roofing, administrators of sites to be reclaimed and recovered, managers of historical/archaeological sites, farming enterprises (especially organic), private citizens, etc.

The system 1 is able to facilitate the monitoring of the green area (for example, the quantity of water required by the plants as a function of the environments and the climate) which is made progressively more efficient thanks to the measurements of the sensors 8. The system 1 is also able to make successive steps for maintenance or re-planting of the green area more efficient according to the dynamics of concentration of pollutants measured by the sensors 8 (for example, in the reclamation of heavy metals from soils, if during the first planting cycles some metals are mainly mitigated, the subsequent cycles are reprogrammed to mitigate the remaining main components).

The system 1 according to the invention makes it possible to obtain a green "Science-based" project without having previous specific skills. The system 1 is structured in such a way as to be easy to use and be divided by design modules and mitigation objectives.

The plants are selected and positioned using artificial intelligence models and a database (the system data) that is periodically updated with the latest scientific research results.

The system 1 is characterised by a strong scientific approach as any reported data can be verified with a corresponding article, report, scientific document, data of or through in situ surveys.

The known types of "Landscape Design" platforms usually use only one design algorithm valid for all green areas and without environmental mitigation objectives. The system 1 according to the invention introduces specific automated design models for different types of green areas, mitigations and maintenance operations.

The system 1 according to the invention applies to the following types of interventions:
- urban green areas/reforestation areas;
- roof garden areas;
- carbon offset projects;
- maintenance activities;
- reclamation of landfills;
- water management;
- controlling the vigour of the plants; and
- noise reduction.

With the use of suitable sensors 8 it is also possible to provide for the irrigation of the green area based on knowledge both of the quantity of rainwater - planned and actually falling - and of the quantity of water exchanged with the ground in the form of vapour (predicted and actual). This information is integrated with the values of vigour monitored and consequently the quantity of water to be introduced by means of actuators for dispensing the water is determined, in such a way as to maintain the required water balance.

In order to obtain forecasts of rainwater and humidity, the green area can also be connected with sensors and with weather services through external control units. If, for example, a plant in an optimum vigour state (that is, without requests for changes in water flow) should require 2 mm/day of water and the weather forecasts were only 1 mm/day of rain, then the system 1, using the processing module 4, would communicate with an irrigation system to send it irrigation instructions such as to dispense only 1 mm of water to the plant.

The information on environmental and climatic data and on the working variables can be provided to the users through a specific citizen-science app. This allows:
1. dissemination of high quality, low-cost monitoring on a large scale alongside ARPA surveys;
2. involvement and raising of awareness among citizens on issues related to climate change, safeguarding and quality of the urban environment;
3. creation of a digitally connected network of urban green spaces aimed at reducing pollutants in the air and collecting specific environmental data.

The use of the system 2 in combination with a technology for acquiring multispectral images makes it possible to assess plant vigour. The optimum vigour value is interpreted by the artificial intelligence module 6 thanks also to a data analysis method that automates the construction of machine learning analytical models. This information synergy between spectrography and machine learning allows improvement of the monitoring and management of the green area. Since the mitigation efficiencies are linked to the vigour, the system 1 makes it possible to optimise the yield of the green areas in terms of capture of pollutants.

Obviously, without prejudice to the principle of the invention, the embodiments and the details of the invention may be varied widely with respect to what has been described and illustrated purely by way of non-limiting example, without thereby departing from the scope of protection of the invention as defined in the appended claims.

## Claims

1. Described is a system for designing green areas (1) comprising:
- a graphical interface module (2) designed to acquire a plurality of input data representing the shape of a green area to be designed, any pollutants present in the green area and design aims;
- a processing module (4) designed to combine the input data with system data representing characteristics of the plants to be used and design parameters and to send it to an artificial intelligence module (6) located in a remote server;
- a plurality of sensors (8) designed to be positioned in the green area for acquiring measurement data representing physical parameters of the green area and sending it to the artificial intelligence module 6, said artificial intelligence module (6) being designed to process the input data, the system data and the measurement data on the basis of predetermined physical-mathematical and artificial intelligence models in order to obtain output data representing a set of plants to be used, their number and their spatial arrangement inside the green area.

2. The system according to claim 2, also comprising an output module (12) designed to display the output data.

3. The system according to claim 1 or 2, also comprising memory means (10) designed to store the system data.

4. The system according to any one of the preceding claims, wherein the system data comprises a *database* which integrates various databases and which contains a plurality of plants catalogued by pollutant emissions and greenhouse gases absorbed, microclimates, habitus, growth dynamics, noise absorption, irrigation and luminous regimes.

5. The system according to any one of the preceding claims, wherein the output data contain a report on the emissions absorbed by the plants, and a description of the management of the green area to be actuated.

6. The system according to any one of the preceding claims, also comprising a plurality of design modules (14) designed to interface with the artificial intelligence module (6) to design the green area as a function of the local pollutants, or as a function of Carbon Neutralit/GHG Gas Emission Offset objectives, or on the basis of a luxuriance of the plants, the irrigation, the reduction of pollutants, the production of biomass and noise reduction.

7. The system according to any one of the preceding claims, wherein said physical-mathematical and artificial intelligence models comprise *phytoremediation*, *multispectral analysis* and *machine learning.*

8. A method for designing green areas comprising the operations of:
- preparing (100) a system for designing green areas (1) according to any one of the preceding claims;
- inserting (102), using the graphical interface module (2), the input data;
- acquiring (104) the measurement data;
- digitally processing (106) the input data, the system data and the measurement data using predetermined physical-mathematical and artificial intelligence models, obtaining the output data;
- displaying (106) said output data.
